# EUROPÄISCHE PATENTSCHRIFT

(11) **EP 2 349 672 B1**
(45) Veröffentlichungstag und Bekanntmachung des Hinweises auf die Patenterteilung: **11.12.2019**
(21) Anmeldenummer: 09783639.9
(22) Anmeldetag: 01.10.2009
(51) Int. Cl.: B29C 45/14, G01D 11/24

(54) **VERFAHREN ZUR HERSTELLUNG EINES GESCHWINDIGKEITS-SENSORELEMENTS**
METHOD FOR PRODUCING A SPEED SENSOR ELEMENT
PROCÉDÉ DE RÉALISATION D'UN ÉLÉMENT DE DÉTECTION DE VITESSE

(30) Priorität: 02.10.2008 DE 102008049956; 19.12.2008 DE 102008064046
(43) Veröffentlichungstag der Anmeldung: 03.08.2011
(73) Patentinhaber: Continental Teves AG & Co. OHG, 60488 Frankfurt am Main (DE)
(72) Erfinder: Döring, Andreas, 65207 Wiesbaden (DE); HUBER, Dietmar, 63128 Dietzenbach (DE); SCHILLINGER, Jakob, 8508 Gaimersheim (DE); DE VOLDER, Edmond, B-9100 Sint-Niklaas (BE); WATZLAWIK, Martin, 63477 Maintal (DE)
(86) Internationale Anmeldenummer: PCT/EP2009/062749
(87) Internationale Veröffentlichungsnummer: WO 2010/037810

(56) Entgegenhaltungen:
- WO-A-97/36729
- WO-A-2007/123310
- WO-A-2008/031657
- US-A- 5 542 171
- US-A1- 2006 118 239

## Beschreibung

Die Erfindung betrifft ein Verfahren zur Herstellung eines Sensorelements.

Druckschrift WO 95/17680 schlägt ein Raddrehzahlsensorelement mit einem Leadframe vor, der beidseitig bestückt ist und ein Gehäuse mit einem Messfühlerelement und einer elektronischen Schaltung, angeordnet auf einer Seite des Leadframes, und einem Magneten, angeordnet auf der anderen Seite des Leadframes, aufweist.

In Druckschrift WO 97/36729 wird ein Verfahren zur Herstellung eines Raddrehzahlsensorelements vorgeschlagen, welcher ein erstes Gehäuseteil umfasst, das Positionierelemente mit integrierten Schmelzelementen aufweist, wobei dieses erste Gehäuseteil in einem Kunststoffspritzvorgang von einem zweiten Gehäuseteil umgeben wird.

Der Erfindung liegt die Aufgabe zu Grunde, ein Verfahren zur Herstellung eines Sensorelements vorzuschlagen, welches kostengünstig durchzuführen ist und/oder eine hohe Herstellungsqualität des Sensorelements ermöglicht.

Diese Aufgabe wird erfindungsgemäß gelöst durch das Verfahren gemäß Anspruch 1.

Der Erfindung liegt der Gedanke zu Grunde, zumindest Teile des Sensorelements während der Herstellung wenigstens einem Plasmabehandlungsvorgang zu unterziehen.

Es können verschiedene Methoden der Generierung von Plasmen zur Plasmabehandlung verwendet werden, wie beispielsweise das Anlegen von hochfrequenten Wechselspannungen an ein Gas oder die diesbezügliche Verwendung von Gleichstrom und/oder die Anregung eines Gases mit Mikrowellen. Beispielhafte Gasgemische zur Plasmabehandlung enthalten Sauerstoff, Argon, Wasserstoff und/oder Stickstoff. Die Art des Gemischs hängt von den speziellen Anforderungen an den Plasmabehandlungsprozess ab, welche sich beispielsweise aus Art der Verunreinigung und dem behandelten Werkstoff ergeben. Abhängig von der Art des Gasgemischs wirkt das Plasma oxidierend oder reduzierend oder aktivierend. Oxidierende Plasmen sind zum Entfernen organischer Verunreinigungen geeignet, während reduzierende Plasmen auch für das Entfernen anorganischer Ablagerungen und/oder zum Abbau von Oxidablagerungen geeignet sind.

Der Plasmabehandlungsvorgang umfasst bevorzugt einen Plasmareinigungsvorgang und/oder einen Plasmaaktivierungsvorgang.

Unter einem Plasmareinigungsvorgang wird vorzugsweise ein trockenes, berührungsloses, chemisches und/oder physikalisches, nicht abrasives Reinigungsverfahren verstanden, mit dem höchste Reinigungsqualitäten erzielt werden können. Insbesondere organische Verunreinigungen werden durch chemische Reaktion mit freien Radikalen des Plasmas beispielsweise in Wasserdampf, Kohlendioxid und/oder CH₄ umgewandelt. Zum chemischen Entfernen von Kontamination enthält das Plasma beispielsweise Sauerstoff oder Wasserstoff oder Argon. Sauerstoff ist dabei zum Entfernen organischer Kontaminationen geeignet und Wasserstoff zum Entfernen anorganischer und/oder organischer Stoffe sowie zum Reduzieren von Oxiden. Der Reinigungsprozess ist zweckmäßigerweise eine Kombination aus einem physikalischen und einem chemischen Wirkprozess oder alternativ vorzugsweise ausschließlich ein chemischer Wirkprozess (ionenfrei).
Physikalisch: Verbindet man beispielsweise den zu reinigenden Gegenstand mit einer Kathode zur Plasmaerzeugung, werden aufgrund des angelegten elektrischen Feldes positive Ionen aus dem Plasma in dessen Richtung beschleunigt. Beim Auftreffen lösen diese Ionen durch direkten Impulsübertrag Atome und Moleküle von der Oberfläche ab.
Chemisch: Angeregter Sauerstoff und Sauerstoffionen bilden beispielsweise bei der Reaktion mit Kohlenwasserstoffen Kohlendioxid und Wasser. Angeregter Wasserstoff bildet beispielsweise Halogenide, Sulfide, CHₓ und Wasserdampf.

Unter einem Plasmaaktivierungsvorgang wird bevorzugt ein Plasmabehandlungsvorgang zur Erhöhung der Oberflächenspannung bzw. -haftung des zu behandelden bzw. aktivierenden Körpers verstanden. Dabei wird die Adhäsion zwischen einem Substrat bzw. dem Körper mit einem aufzutragenden Material, bspw. Moldmaterial verstärkt. Das Substrat bzw. dieser Körper ist somit leichter von einem, insbesondere flüssigen, Mittel oder Stoff zu benetzen bzw. haftend einzuhüllen. Der Kontaktwinkel eines Tropfens auf dem Körper ist dabei ein gängiges Maß für die Oberflächenspannung des Körpers. Ist die Oberfläche des Körpers hydrophob (wasserabweisend) hat er eine geringe Oberflächenspannung. Mittels eines Plasmaaktivierungsvorgangs erreicht man wie mit einem Haftvermittler eine Erhöhung der Oberflächenspannung. Die Oberfläche des Körpers ist nach dem Plasmaaktivierungsvorgang hydrophil bzw. gut benetzbar, der Kontaktwinkel ist verringert und die Neigung zur Delamination ist geringer. Für einen Plasmaaktivierungsvorgang wird beispielsweise Stickstoff und/oder Sauerstoff verwendet. Ein Plasmaaktivierungsvorgang wird beispielsweise zur Verbesserung der Haftung von Klebern oder Beschichtungen auf bestimmten Kunststoffen verwendet.

Ein Basiselement und/oder ein Trägerelement des Sensorelements werden erfindungsgemäß vor einem Bestückungsvorgang und/oder vor einem Kontaktierungsvorgang mit elektrischen Anschlussmitteln einem Plasmabehandlungsvorgang unterzogen, erfindungsgemäß einem Plasmareinigungsvorgang.

Unter einem Basiselement wird bevorzugt ein Leadframe und/oder ein Strukturelement des Sensorelements und/oder ein Trägerstreifen/eine Trägerfolie oder ein MID-Element (Molded Interconnect Device bzw. spritzgegossener Schaltungsträger), welches einen Kunststoffkörper bzw. einen Spitzgusskörper umfasst, der auf diesen aufgebrachte und/oder von diesem umschlossene Leiterbahnen aufweist, die beispielsweise aus Metall und/oder einem leitfähigen Kunststoff ausgebildet sind, verstanden.

Vor zumindest einem Umspritzungsvorgang, insbesondere einem Kunststoffspritzgussvorgang, werden bevorzugt zumindest Teile des Sensorelements einem Plasmabehandlungsvorgang unterzogen, insbesondere einem Plasmaaktivierungsvorgang. Dies erfolgt besonders bevorzugt nach mindestens einem Bestückungsvorgang.

Das Verfahren umfasst zweckmäßigerweise einen Plasmareinigungsvorgang vor einem Kontaktierungsvorgang zur deutlichen Verminderung der Korrosionsanfälligkeit und einen Plasmaaktivierungsvorgang vor einem Umspritzungsvorgang zur deutlichen Verminderung der Delaminationsanfälligkeit.

Das Sensorelement wird vorzugsweise mit wenigstens einem Messfühlerelement und/oder zumindest einer elektronischen Schaltung bestückt, welche insbesondere auf dem Basiselement und/oder dem Trägerelement direkt oder indirekt angeordnet werden, besonders bevorzugt auf einem Trägersockel bzw. einer Bondinsel bzw. einem die-pad des Basiselements. Das Messfühlerelement und/oder die elektrische Schaltung werden ganz besonders bevorzugt nach einem ball-stich-on-ball-Bondverfahren (BSOB) bzw. einem stich-on-bump-Bondverfahren (SOB) elektrisch kontaktiert, wodurch eine hohe Zug- und Scherfestigkeit der elektrischen Kontaktierungen erreicht werden kann. Alternativ werden das Messfühlerelement und/oder die elektrische Schaltung ganz besonders bevorzugt nach einem wedge-ball-Bondverfahren oder nach einem reversestich-on-ball-Bondverfahren (RSOB) elektrisch kontaktiert.

Unter einem Messfühlerelement wird vorzugsweise ein Magnetoelektrisches-Wandlerelement, insbesondere ein AMR-, GMR-, oder ein anderes magnetoresistives Element oder ein Hall-Element, verstanden, welches besonders bevorzugt eine Brückenstruktur aufweist und auch als Brücken-die bezeichnet wird. Das Messfühlerelement weist zweckmäßigerweise kombinierte Magneto-elektrische-Wandlerelemente unterschiedlicher Wirkweise auf.

Das Basiselement und/oder das Trägerelement werden bevorzugt beidseitig mit jeweils zumindest einem Bauelement bestückt.

Das Messfühlerelement und wenigstens ein Teil des Basiselements und/oder des Trägerelements werden vorzugsweise umspritzt, wodurch ein erstes Gehäuse ausgebildet wird. Zusätzlich wird zumindest ein Teil des Basiselements und/oder des Trägerelements und insbesondere ein elektronisches Schutzelement, umspritzt, wodurch ein zweites Gehäuse ausgebildet wird. Das erste und zweite Gehäuse weisen dabei besonders bevorzugt einen definierten Abstand zueinander auf. Ganz besonders bevorzugt werden das erste und das zweite Gehäuse in einem zusätzlichen Umspritzungsvorgang gemeinsam umspritzt, beispielsweise mittels eines Overmold-Spritzgießvorgangs, wodurch ein gemeinsames drittes Gehäuse ausgebildet wird.

Unter einem Overmold-Spritzgießvorgang wird bevorzugt ein Spritzgießvorgang verstanden, bei welchem ein Thermoplast in eine Außenform, beispielsweise eine kundenspezifische Außenform, insbesondere mittels eines Schneckentriebs gepresst wird. Besonders bevorzugt wird über eine Extruder-Schnecke ein zähflüssiges Moldmaterial, beispielsweise Polyamid, in die Spritzgießform bzw. Mold-Kavität gedrückt, wonach das thermoplastische Material durch Abkühlung an der Spritzgießformwand erstarrt. Danach wird das fertige Spritzgießbauteil dem Werkzeug entnommen.

Es ist bevorzugt, dass insbesondere am Ende des Herstellungsverfahrens, das Sensorelement einem zusätzlichen Plasmabehandlungsvorgang unterzogen wird, insbesondere einem Plasmareinigungsvorgang, wodurch die freiliegenden Kontakte bzw. Anschlussmittel des Sensorelements in relativ geringem Maße korrodieren bzw. zu Korrosion neigen. Außerdem kann aufgrund des Plasmareinigungsvorgangs auf einen Galvanisierungsvorgang, beispielsweise ein Verzinnen oder Vernickeln, zum Schutz der freiliegenden Kontakte bzw. Anschlussmittel verzichtet werden. Anschließend wird das Sensorelement zweckmäßigerweise direkt luftdicht verpackt.

Das Verfahren zur Herstellung des Sensorelements umfasst vorzugsweise folgende Schritte:
Ausstanzen eines Basiselements bzw. Leadframes bzw. Trägerstreifens aus einem Rohkörper, welcher insbesondere aus einem Metallblech ausgebildet ist. Alternativ wird ein Trägerstreifen/eine Trägerfolie oder ein MID-Element als Basiselement verwendet. Anschließend werden eine Oberflächenbeschichtung und/oder wenigstens eine Kontaktstelle auf zumindest einer Seite des Leadframes bzw. Basiselements aufgebracht. Im Anschluss erfolgt die Bestückung des Leadframes bzw. Basiselements mit wenigstens einem elektronischen Bauelement.

Es ist bevorzugt, dass im Zuge der Bestückung des Basiselements zunächst eine erste Seite bzw. eine erste Fläche des Basiselements mit einem ersten Klebemittel (dispense) versehen wird. Dieses erste Klebemittel ist wahlweise elektrisch leitfähig oder isolierend und weist eine relativ gute Wärmeleitfähigkeit auf. Danach wird auf diese erste Seite wenigstens eine elektronische Schaltung, auch als ASIC-die bezeichnet und/oder mindestens ein Messfühlerelement, welches besonders bevorzugt als Brücke ausgebildet ist, aufgebracht. Der ASIC-die dient ganz besonders bevorzugt als Montageträger für das Messfühlerelement. Dabei ist das Messfühlerelement beispielsweise mittels einer FlipChip-Montage auf dem ASIC-die angeordnet.

Das ASIC-die und das Messfühlerelement sind zweckmäßigerweise als ein integriertes Bauelement ausgebildet.

Bevorzugt wird danach das Klebemittel bzw. werden der Leadframe bzw. Basiselement sowie die Bauelemente auf der ersten Seite des Basiselements erwärmt, wodurch die Verbindung mittels des ersten Klebemittels aushärtet.

Danach wird der Leadframe bzw. Basiselement zweckmäßigerweise einem Plasmabehandlungsvorgang, insbesondere einem Plasmareinigungsvorgang, unterzogen, wodurch die Oberfläche des Basiselements und der Bauteile zumindest teilweise von korrosionsfördernden Sulfid-, Halogen- und/oder Kohlenstoff-Kontaminationen gereinigt werden. Zudem erfolgt eine Reduktion der Oxidschicht. Dies ist besonders vorteilhaft zur Gewährleistung von zuverlässigen elektrischen Kontaktierungen zwischen Bonddrähten und dem Leadframe bzw. dem Basiselement und/oder mit zumindest einer Kontaktstelle des ASIC-dies oder Messfühlerelements. Außerdem dient diese Reinigung zur Erreichung einer relativ hohen Dichtheit im Zuge einer zumindest teilweisen Umspritzung des Leadframes bzw. des Basiselements.

Nach dem Bestücken des Leadframes bzw. Basiselements bzw. eines entsprechenden Bestückungsvorgangs und insbesondere nach einem anschließenden Plasmabehandlungsvorgang, werden bevorzugt zumindest das ASIC-die und/oder das Messfühlerelement mittels eines Draht-Bondvorgangs elektrisch leitend miteinander und/oder mit dem Leadframe bzw. Basiselement verbunden. Dabei werden besonders bevorzugt zunächst an allen Kontaktstellen auf dem Basiselement und auf Kontaktierungspads bzw. auf Kontakierungsmitteln der entsprechenden Bauelemente in geeigneter Weise Bumps bzw. Bondhügel bzw. Lothügel bzw. eine bondbare Schicht aufgebracht. Danach werden die jeweiligen Bonddrähte gezogen, wobei dies nach dem sogenannten ball-stich-on-ball-Bondverfahren (BSOB) bzw. stich-on-bump-Bondverfahren (SOB) durchgeführt wird. Ganz besonders bevorzugt werden die Bonddrähte, welche einen Kontakt mit dem ASIC-die aufweisen, von den Kontaktierungspads des ASIC-die weg zu dem jeweiligen Zielpunkt und dem dortigen Bump der elektrischen Verbindung hingezogen. Durch diese Art des Bondvorgangs werden unerwünschte thermische und mechanische Beeinflussungen der Bauelemente relativ gering gehalten. Alternativ werden das Messfühlerelement und/oder die elektrische Schaltung ganz besonders bevorzugt nach einem wedge-ball-Bondverfahren oder nach einem reverse-stich-on-ball-Bondverfahren (RSOB) elektrisch kontaktiert.

Es ist zweckmäßig, dass im Zuge der Kontaktierung mindestens eines, insbesondere mehrere, der oben genannten Bondverfahren zur Kontaktierung verschiedener elektrischer Kontakte durchgeführt wird. Besonders bevorzugt werden die elektronischen Bauelemente mittels des stich-on-bump-Bondverfahrens (SOB) kontaktiert und das Basiselement bzw. der Leadframe mittels des wedge-ball-Bondverfahrens oder eines anderen Wedge-Bondverfahrens. Alternativ vorzugsweise werden sämtliche elektrische Kontaktierungen mittels des stich-on-bump-Bondverfahrens (SOB) bzw. (BSOB) durchgeführt.

Das Kontaktierungspad des ASIC-die ist zweckmäßigerweise zumindest teilweise aus Aluminium ausgebildet und/oder das Kontaktierungspad des Messfühlerelements aus Gold. Das Kontaktierungspad des ASIC-die aus Aluminium ist insbesondere als Metallisierung mit einer Dicke von weniger als 1um ausgebildet.

Als Bonddraht wird bevorzugt Golddraht verwendet, welcher als Zusatzstoff Palladium aufweist bzw. mit geringen Mengen Palladium dotiert ist.

Die oben vorgeschlagenen Kontaktierungen ermöglichen eine hohe Temperaturbelastbarkeit, insbesondere für Temperaturen bis 180°C, beispielweise für die Verwendung in Kraftfahrzeugen, sowie eine hohe Zug- und Scherfestigkeit.

Zweckmäßigerweise wird anschließend auf einer zweiten, der ersten Seite gegenüberliegenden, Seite des Leadframes bzw. Basiselements ein zweites Klebemittel aufgebracht. Danach wird auf der zweiten Seite ein magnetisches Mittel, insbesondere ein Ferrit, im Bereich gegenüber der Brücke so angeordnet, dass sich besonders bevorzugt der Massenschwerpunkt des Magneten senkrecht bezüglich des Basiselements über dem Massenschwerpunkt und/oder dem geometrischen Mittelpunkt der sensitiven Fläche des Messfühlerelementes befindet. Ganz besonders bevorzugt wird zusätzlich ein elektronisches Schutzelement mit einem definierten Abstand zum ASIC-die wahlweise auf der ersten Seite oder der zweiten Seite des Basiselements angeordnet. Dieses Schutzelement wird zweckmäßigerweise auf derselben Bondinsel wie der ASIC-die oder alternativ vorzugsweise an einer anderen Stelle des Basiselements in einem definierten Abstand zum ASIC-die angebracht, insbesondere ist das Schutzelement dabei mit zwei Kontaktierungsbeinen des Basiselement mechanisch und elektrisch verbunden. Letzteres bietet den Vorteil, dass die mechanische Stabilität der Anschlusspins zum Moldgehäuse verbessert wird. Das Schutzelement wird dabei zweckmäßigerweise von dem zweiten Gehäuse umgeben.

Das zweite Klebemittel ist vorzugsweise elektrisch leitfähig ausgebildet.

Das erste und das zweite Klebemittel werden bevorzugt punktförmig oder als kreuzende Striche dosiert, in der Weise, dass nach dem Bestückungsvorgang bzw. "Die-Attach" die Ecken des jeweiligen Bauelements ausreichend mit Klebemittel beaufschlagt sind.

Das elektronische Schutzelement ist bevorzugt als Kondensator oder alternativ vorzugsweise als Doppel-Zehnerdiode oder Varistor ausgebildet. Die elektrische Kontaktgabe erfolgt über Klebeverbindung oder Drahtbondtechnik.

Anschließend wird das zweite Klebemittel zweckmäßigerweise ebenfalls durch Erwärmung ausgehärtet.

Das Erwärmen wird, insbesondere jeweils, zweckmäßigerweise in einem Ofen durchgeführt.

Erfindungsgemäß wird nach der kompletten Bestückung des Leadframes bzw. Basiselements ein, unmittelbar vor dem Umspritzungsvorgang, insbesondere als Transfer-Molden durchgeführt, ein zusätzlicher Plasmabehandlungsvorgang durchgeführt. Dieser zusätzliche Plasmabehandlungsvorgang umfasst besonders bevorzugt einen Plasmareinigungsvorgang und danach einen Plasmaaktivierungsvorgang. Der Plasmaaktivierungsvorgang betrifft dabei ganz besonders bevorzugt die ASIC-die, Kleber- und Ferrit-Oberflächen, wodurch eine bessere Haftung des Moldmaterials bzw. Spritzgussmaterials ermöglicht wird.

Unter Transfer-Molden wird bevorzugt ein Spritzgießvorgang verstanden, bei welchem ein festes und/oder vorgemischtes Moldmaterial unter einem erhöhten Druck und erhöhter Temperatur verflüssigt wird und anschließend in eine Spritzgussform, insbesondere unter erhöhtem Druck, geleitet wird, in welcher das Moldmaterial zu einem Duroplast-Körper erstarrt bzw. auskristallisiert, wobei dieser Duroplast-Körper im Wesentlichen nicht mehr schmelzbar ist.

Das ASIC-die, das Messfühlerelement, sowie das magnetische Mittel werden zweckmäßigerweise gemeinsam umspritzt, wodurch ein erstes Gehäuse um diese Bauelemente ausgebildet wird. Besonders bevorzugt wird zusätzlich das elektronische Schutzelement separat umspritzt, wodurch ein zusätzliches zweites Gehäuse ausgebildet ist. Als Umspritzungstechnik wird bevorzugt das Transfer-Molden angewandt.

Es ist bevorzugt, dass das Basiselement eines Sensorelements mit Basiselement anderer Sensorelemente über Verbindungsstege im Wesentlichen in Form einer Kette bzw. Streifen verbunden ist. Nach dem Umspritzungsvorgang werden die Basiselement, insbesondere durch einen Stanzvorgang, vereinzelt.

Es ist zweckmäßig, dass der Basiselement zumindest eine Bondinsel/ einen Trägersockel/ ein die-pad aufweist, auf welchem das ASIC-die und das Messfühlerelement auf der ersten Seite und das magnetische Mittel auf der zweiten Seite angeordnet sind. Außerdem weist das Basiselement mindestens zwei Kontaktierungsanschlüsse auf, welche zum Teil mit der Bondinsel verbunden sind.

Nach dem Umspritzen und insbesondere Vereinzeln der Basiselemente bzw. Leadframes wird vorzugsweise das magnetische Mittel magnetisiert. Anschließend wird besonders bevorzugt der Leadframe mit Steckerterminals oder einem Kabel durch Crimpen und/oder Schweißen und/oder Löten und/oder Kleben elektrisch leitend verbunden, dabei werden ganz besonders bevorzugt die Kontaktierungsanschlüsse mit dem Stecker oder Kabel verbunden werden.

Das ASIC-die sowie das Messfühlerelement bzw. das Brücken-die weisen vorzugsweise im Wesentlichen die gleiche Höhe auf und ragen deshalb im Wesentlichen gleichweit von der ersten Seite des Basiselements ab. Dabei sind das ASIC-die und das Brücken-die um eine definierte Länge voneinander beabstandet auf der ersten Seite des Basiselements angeordnet. Es hat sich herausgestellt, dass diese Anordnung vorteilhaft für die gemeinsame Umspritzung ist. Die definierte Länge zwischen ASIC-die und Brücken-die bzw. dieser Abstand ist besonders bevorzugt größer als 40pm ausgebildet, um ein den Klebevorgang dieser Bauelemente sowie den anschließenden gemeinsamen Umspritzungsvorgang problemfrei zu ermöglichen.

Das Basiselement bzw. der Leadframe umfasst bevorzugt zwei oder mehr Kontaktierungsbeine, welche insbesondere durch das zweite Gehäuse miteinander verbunden sind und welche besonders bevorzugt teilweise aus dem dritten, gemeinsamen Gehäuse des Sensorelements als Kontaktelemente des Sensorelements herausragen.

Das erfindungsgemäße Verfahren ist vorzugsweise zur Herstellung von Sensorelementen vorgesehen, insbesondere von Sensorelementen für sicherheitskritische Anwendungen. Besonders bevorzugt ist das Verfahren zur Herstellung von Geschwindigkeitssensorelementen, ganz besonders bevorzugt für Kraftfahrzeuge, vorgesehen.

Weitere bevorzugte Ausführungsformen ergeben sich aus den Unteransprüchen und den nachfolgenden Beschreibungen von Ausführungsbeispielen an Hand von Figuren.

Es zeigen in schematischer Darstellung
- Fig. 1 bis 3: Ausführungsbeispiele des Sensorelements sowie
- Fig. 4: ein beispielhaftes Ablaufdiagramm des Verfahrens zur Herstellung eines Sensorelements.

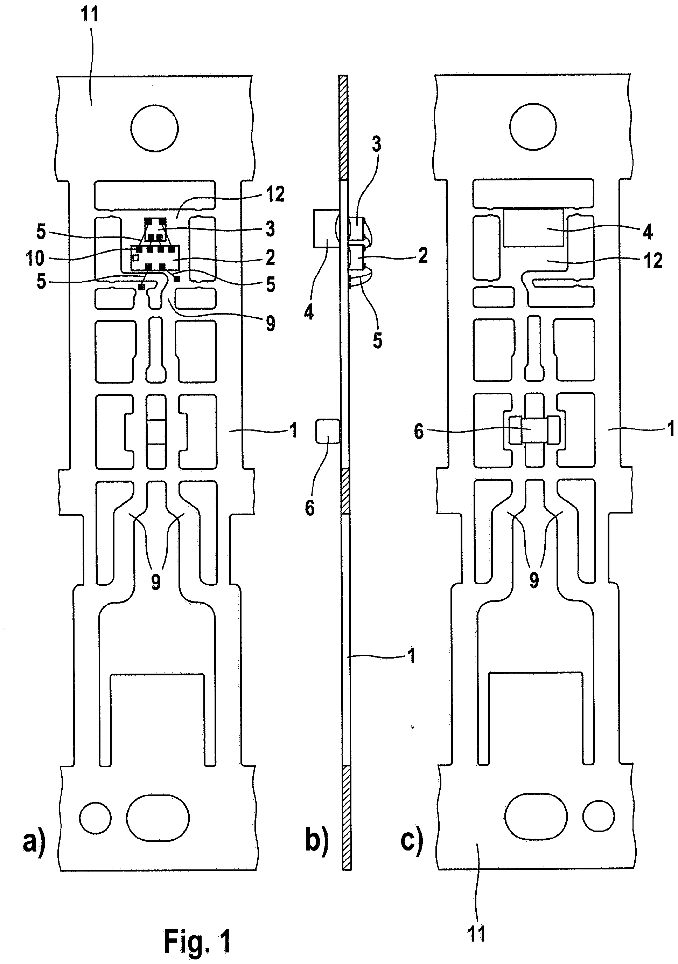

In Fig. 1 ist ein beispielhafter Sensorelement dargestellt, wobei Fig. 1 a) eine Draufsicht auf die erste Seite des Basiselements 1, Fig. 1 b) eine Seitenansicht sowie Fig. 1 c) eine Draufsicht auf die zweite Seite bzw. die Unterseite des Basiselements 1 zeigt. Basiselement 1 ist beispielgemäß als Leadframe aus Metall ausgebildet.

Die erste Seite Basiselements 1 ist mit einem Messfühlerelement 3 und einem ASIC-die 2 bestückt, welche durch elektrische Anschlussmittel bzw. "wire bonds" miteinander und mit den Kontaktierungsbeinen 9 des Basiselements 1 verbunden sind. Das Messfühlerelement 3 und das ASIC-die 2 ragen im Wesentlichen gleich weit von Basiselement 1 ab bzw. sind gleich hoch ausgebildet. Die Verdrahtung bzw. elektrische Kontaktierung ist beispielgemäß entsprechend einem ball-stich-on-ball-Bondverfahren ausgebildet, wobei die AU-Drähte 5 mit Bondhügeln bzw. Bumps bzw. Gold-Bumps verbunden sind, die auf den Kontaktierungsbeinen 9 des Basiselements 1 und auf Kontaktierungspads 10 des Messfühlerelements 3 und des ASIC-dies 2 angeordnet sind. Bei dem in Fig. 1 dargestellten Ausführungsbeispiel ist das dargestellte Sensorelement bezüglich seines Basiselements mittels eines Bands 11 oder einer anderen Verbindung mit weiteren Basiselementen verbunden. Messfühlerelement 3 und ASIC-die 2 sind auf einem Trägersockel 12 des Basiselements 1 angeordnet.

Der Trägersockel 12 bzw. die Bondinsel ist auf der zweiten Seite des Basiselements 1 mit einem magnetischen Mittel 4, welches als Ferrit ausgebildet ist, bestückt. Außerdem ist die zweite Seite des Basiselements 1 mit einem elektronischen Schutzelement 6, beispielgemäß als Kondensatorelement ausgebildet, bestückt, welches in einem definierten Abstand zu Trägersockel 12 bzw. ASIC-die 2 angeordnet und mit zwei Kontaktierungsbeinen 9 verbunden ist.

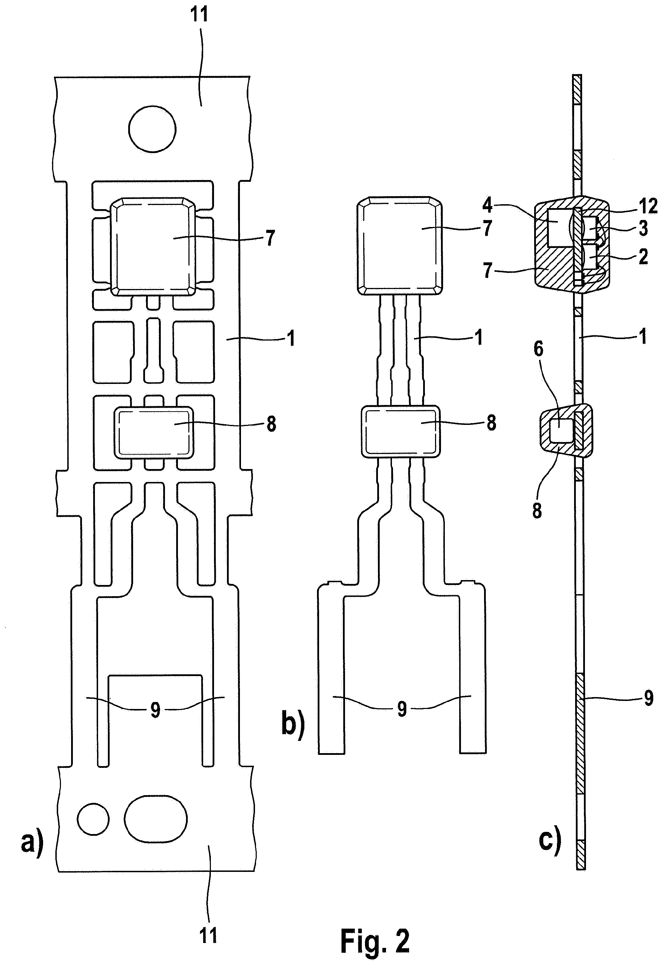

Fig. 2 zeigt ein Ausführungsbeispiel eines Sensorelements mit einem ersten und einem zweiten Gehäuse 7, 8, welche in einem Spritzgussverfahren aus einem duroplastischen Mold-Compound, beispielsweise Epoxy, ausgebildet ist. In Fig. 2 a) ist der Sensorelement noch bezüglich seines Basiselements 1 durch Band 11 mit weiteren Sensorelementen verbunden. Basiselement 1 weist dabei zwei Kontaktierungsbeine 9 und einen Trägersockel auf, wobei dieser Trägersockel durch das erste Gehäuse 7 umhüllt ist. Fig. 2 b) zeigt den beispielhaften Sensorelement nach einem Vereinzelungsprozess, in dem nur der Teil des Basiselements 1 ausgestanzt und weiterverarbeitet wird, der für den späteren, fertigen Sensorelement relevant ist. Fig. 2 c) zeigt eine seitliche Schnittansicht dieses beispielgemäßen Sensorelements. Dabei enthält erstes Gehäuse 7 aus gespritztem Epoxy einen ASIC-die 2 und ein Messfühlerelement 3, angeordnet auf einer ersten Seite des Trägersockels 12 des Basiselements 1 sowie ein magnetisches Mittel 4 bzw. beispielgemäß einen Ferrit, angeordnet auf der zweiten Seite dieses Trägersockels. Das zweite Gehäuse 8 aus gespritztem Epoxy umfasst ein Kondensatorelement als elektronisches Schutzelement 6, welches mit den beiden Kontaktierungsbeinen 9 verbunden ist.

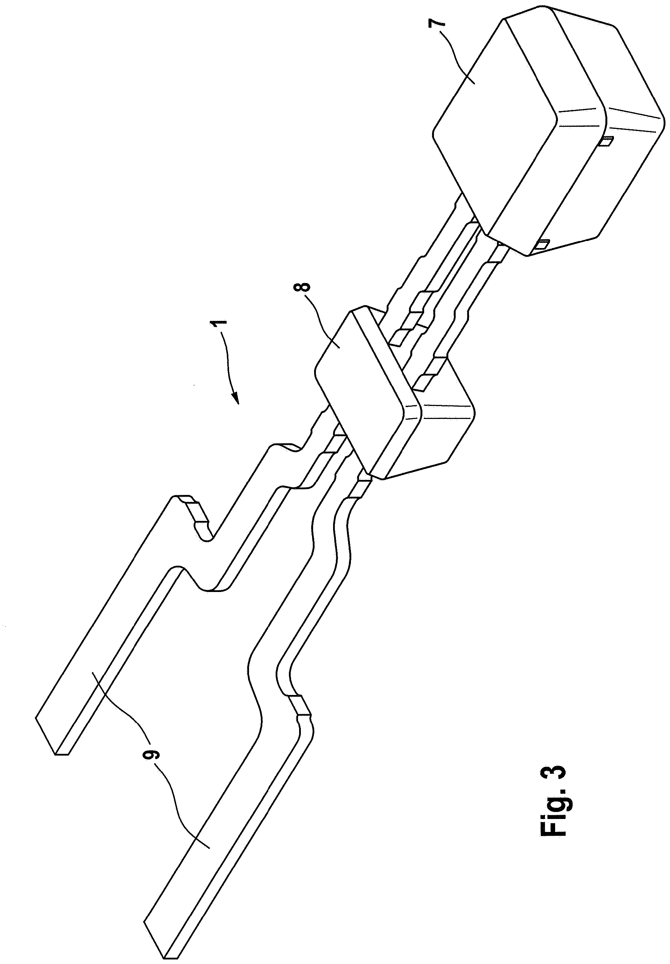

Fig. 3 veranschaulicht ein beispielhaftes Sensorelement umfassend einen Basiselement 1 mit Kontaktierungsbeinen 9 und ein erstes 7 und zweites 8 Gehäuse aus Spitzguss. Das erste Gehäuse 7 umfasst ein nicht dargestelltes Messfühlerelement, einen ASIC-die sowie ein magnetisches Mittel. Das zweite Gehäuse 8 umfasst beispielhaft ein elektronisches Schutzelement oder ist in einem alternativen Ausführungsbeispiel "leer", besteht als nur aus dem umspritzten Teil des Basiselements und der Spritzgussmasse selbst. Dieses zweite Gehäuse 8 dient dabei außerdem der mechanischen Entlastung, insbesondere einer Zugentlastung, bezüglich der Kontaktierungsbeine 9.

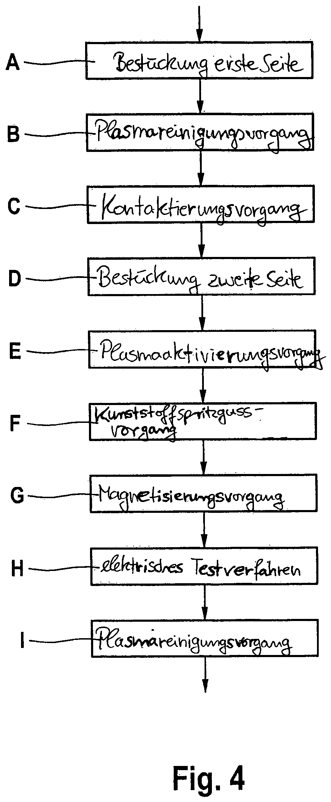

Anhand der Fig. 4 ist ein beispielhaftes Verfahren zur Herstellung eines Sensorelements in einem Flussdiagramm veranschaulicht.

Dabei wird der Basiselement bzw. Leadframe in einem Verfahrensschritt A "assemble Ist side" von einer ersten Seite bestückt. In diesem Verfahrensschritt A wird auf einen Teil der ersten Seite des Basiselements, beispielgemäß auf die erste Seite eines Trägersockels, ein erstes, elektrisch isolierendes und relativ gut wärmeleitfähiges Klebemittel aufgebracht, was auch als "adhesive dispensing" bezeichnet wird. Danach wird ein ASIC-die und ein Messfühlerelement auf dieser ersten Seite angeordnet bzw. angeklebt, was auch als "die attach" bezeichnet werden kann. Danach wird das erste Klebemittel in einem Ofen ausgehärtet, "curing".

Anschließend wird ein Plasmareinigungsvorgang, "plasma cleaning", in Verfahrensschritt B durchgeführt. Dies dient der Vorbereitung eines elektrischen Kontaktierungsverfahrens.

Danach erfolgt ein Kontaktierungsvorgang C, "wire bonding", der auf der ersten Seite des Basiselements angeordneten Bauelemente bzw. des Messfühlerelements und des ASIC-dies, beispielgemäß nach einem ball-stich-on-ball-Bondverfahren mit AU-Draht.

Anschließend erfolgt ein Bestückungsvorgang D der zweiten Seite des Basiselements, "assemble 2nd side". Dabei wird beispielhaft ein Teil der zweiten Seite des Basiselements mit einem zweiten Klebemittel, das elektrisch leitfähig ist, benetzt, "adhesive dispensing", wonach ein magnetisches Mittel und ein elektronisches Schutzelement zur Verbesserung der EMV-Eigenschaften des Sensorelements auf der zweiten Seite, voneinander beabstandet angeordnet werden. Anschließend wird das zweite Klebemittel in einem Ofen ausgehärtet, "curing".

Nach den Bestückungsvorgängen wird ein Plasmaaktivierungsvorgang E, "plasma activation", durchgeführt bzw. der Sensorelements wird diesem Plasmaaktivierungsvorgang unterzogen.

Anschließend werden in einem Kunststoffspritzgussvorgang F, "transfer molding", ein erstes und ein zweites Gehäuse ausgebildet, welche die zuvor auf dem Basiselement angeordneten Bauelemente umfassen. Der Spritzguss der Gehäuse wird in einem Ofen ausgehärtet, "post mold curing".

Danach erfolgt ein Magnetisierungsvorgang G des magnetischen Mittels, wonach ein elektrisches Testverfahren H, "electrical testing", des Sensorelements durchgeführt wird, bei dem die Funktionsfähigkeit des Messfühlerelements im Zusammenwirken mit dem magnetischen Mittel und die Funktionsfähigkeit des ASIC-dies geprüft wird.

Anschließend wird das Sensorelement einem Plasmareinigungsvorgang I "plasma cleaning" unterzogen, der die Korrosionsanfälligkeit des Sensorelements bzw. der freiliegenden elektrischen Kontakte des Sensorelements vermindert. Hierdurch braucht kein zusätzlicher Galvanisierungsvorgang, beispielsweise ein Verzinnen oder Vernickeln der freiliegenden elektrischen Kontakte, durchgeführt werden.

Alternativ erfolgt gar keine zusätzliche Behandlung des Sensorelements zum Schutz vor Korrosion sondern eine geeignete Verpackung des Sensorelements, beispielsweise mittels einer luftdichten Verpackung/ in einem luftdichten Beutel.

## Patentansprüche

1. Verfahren zur Herstellung eines Sensorelements, wobei zumindest Teile des Sensorelements während der Herstellung wenigstens einem Plasmabehandlungsvorgang (B, E, I) unterzogen werden, **dadurch gekennzeichnet, dass** ein Basiselement (1) und/oder ein Trägerelement des Sensorelements vor einem Bestückungsvorgang (A, D) und/oder vor einem Kontaktierungsvorgang (C) mit elektrischen Anschlussmitteln (5) einem Plasmareinigungsvorgang (B, I), unterzogen wird, wobei
nach der kompletten Bestückung des Leadframes bzw. Basiselements, unmittelbar vor einem Umspritzungsvorgang, ein zusätzlicher Plasmabehandlungsvorgang durchgeführt wird, welcher einen Plasmareinigungsvorgang und danach einen Plasmaaktivierungsvorgang umfasst.

2. Verfahren nach Anspruch 1, **dadurch gekennzeichnet, dass** der Plasmabehandlungsvorgang einen Plasmareinigungsvorgang (B, I) und/oder einen Plasmaaktivierungsvorgang (E) umfasst.

3. Verfahren nach Anspruch 1 oder 2, **dadurch gekennzeichnet, dass** vor zumindest einem Umspritzungsvorgang (F), insbesondere einem Kunststoffspritzgussvorgang, zumindest Teile des Sensorelements einem Plasmabehandlungsvorgang unterzogen werden, insbesondere einem Plasmaaktivierungsvorgang (E).

4. Verfahren nach mindestens einem der Ansprüche 1 bis 3, **dadurch gekennzeichnet, dass** das Sensorelement mit wenigstens einem Messfühlerelement (3) und/oder zumindest einer elektronischen Schaltung (2) bestückt wird, welche insbesondere auf dem Basiselement (1) und/oder dem Trägerelement direkt oder indirekt angeordnet werden.

5. Verfahren nach Anspruch 4, **dadurch gekennzeichnet, dass** das Messfühlerelement (3) und/oder die elektronische Schaltung (2) nach einem ball-stich-on-ball-Bondverfahren elektrisch kontaktiert (C) werden.

6. Verfahren nach mindestens einem der Ansprüche 1 bis 5, **dadurch gekennzeichnet, dass** das Basiselement (1) und/oder das Trägerelement beidseitig mit jeweils zumindest einem Bauelement (2, 3, 4, 6) bestückt werden.

7. Verfahren nach mindestens einem der Ansprüche 4 bis 6, **dadurch gekennzeichnet, dass** zumindest das Messfühlerelement (3) und wenigstens ein Teil des Basiselements (1, 12) und/oder des Trägerelements umspritzt (F) werden, wodurch ein erstes Gehäuse (7) ausgebildet wird und dass wenigstens ein Teil des Basiselements (1) und/oder des Trägerelements und insbesondere ein elektronisches Schutzelement (6), umspritzt (F) werden, wodurch ein zweites Gehäuse (8) ausgebildet wird, welches insbesondere einen definierten Abstand zum ersten Gehäuse (7) aufweist.

8. Verfahren nach Anspruch 7, **dadurch gekennzeichnet, dass** das erste (7) und das zweite (8) Gehäuse in einem zusätzlichen Umspritzungsvorgang gemeinsam umspritzt werden, wodurch ein gemeinsames drittes Gehäuse ausgebildet wird.

9. Verfahren nach mindestens einem der Ansprüche 1 bis 8, **dadurch gekennzeichnet, dass**, insbesondere am Ende des Herstellungsverfahrens, das Sensorelement einem zusätzlichen Plasmabehandlungsvorgang (I) unterzogen wird.

## Claims

1. Method for producing a sensor element, wherein at least parts of the sensor element are subjected to at least one plasma treatment process (B, E, I) during production, **characterized in that** a base element (1) and/or a carrier element of the sensor element is subjected to a plasma cleaning process (B, I) before an equipping process (A, D) and/or before a contact-connecting process (C) with electrical connection means (5),
wherein
after the complete process of equipping the leadframe or base element, directly before an encapsulation-by-molding process, an additional plasma treatment process is carried out, which comprises a plasma cleaning process and then a plasma activation process.

2. Method according to Claim 1, **characterized in that** the plasma treatment process comprises a plasma cleaning process (B, I) and/or a plasma activation process (E).

3. Method according to Claim 1 or 2, **characterized in that** at least parts of the sensor element are subjected to a plasma treatment process, in particular a plasma activation process (E), before at least one encapsulation-by-molding process (F), in particular a plastic injection molding process.

4. Method according to at least one of Claims 1 to 3, **characterized in that** the sensor element is equipped with at least one measurement probe element (3) and/or at least one electronic circuit (2), which are arranged directly or indirectly in particular on the base element (1) and/or the carrier element.

5. Method according to Claim 4, **characterized in that** the measurement probe element (3) and/or the electronic circuit (2) are electrically contact-connected (C) according to a ball-stitch-on-ball bonding method.

6. Method according to at least one of Claims 1 to 5, **characterized in that** the base element (1) and/or the carrier element are equipped with in each case at least one component (2, 3, 4, 6) on both sides.

7. Method according to at least one of Claims 4 to 6, **characterized in that** at least the measurement probe element (3) and at least one part of the base element (1, 12) and/or of the carrier element are encapsulated by molding (F), as a result of which a first housing (7) is formed, and **in that** at least one part of the base element (1) and/or of the carrier element and in particular an electronic protection element (6) are encapsulated by molding (F), as a result of which a second housing (8) is formed, which in particular is at a defined distance from the first housing (7).

8. Method according to Claim 7, **characterized in that** the first (7) and the second (8) housing are jointly encapsulated by molding in an additional encapsulation-by-molding process, as a result of which a common third housing is formed.

9. Method according to at least one of Claims 1 to 8, **characterized in that**, in particular at the end of the production method, the sensor element is subjected to an additional plasma treatment process (I).

## Revendications

1. Procédé de fabrication d'un élément capteur, au moins des parties de l'élément capteur étant soumises à au moins une opération de traitement au plasma (B, E, I) pendant la fabrication, **caractérisé en ce qu'**un élément de base (1) et/ou un élément porteur de l'élément capteur est soumis à une opération de nettoyage au plasma (B, I) avant une opération de garnissage (A, D) et/ou avant une opération de mise en contact (C) avec des moyens de raccordement électriques (5),
après le garnissage complet de la grille de connexion ou de l'élément de base, immédiatement avant une opération de surmoulage, une opération de traitement au plasma supplémentaire est effectuée laquelle comprend une opération de nettoyage au plasma et ensuite une opération d'activation au plasma.

2. Procédé selon la revendication 1, **caractérisé en ce que** l'opération de traitement au plasma comprend une opération de nettoyage au plasma (B, I) et/ou une opération d'activation au plasma (E).

3. Procédé selon la revendication 1 ou 2, **caractérisé en ce qu'**avant une opération de surmoulage (F), notamment une opération de moulage par injection de matière plastique, au moins des parties de l'élément capteur sont soumises à une opération de traitement au plasma, notamment une opération d'activation au plasma (E).

4. Procédé selon au moins l'une des revendications 1 à 3, **caractérisé en ce que** l'élément capteur est garni d'au moins un élément sonde de mesure (3) et/ou d'au moins un circuit électronique (2), lequel sont notamment disposés directement ou indirectement sur l'élément de base (1) et/ou l'élément porteur.

5. Procédé selon la revendication 4, **caractérisé en ce que** l'élément sonde de mesure (3) et/ou le circuit électronique (2) sont mis en contact électrique (C) selon un procédé d'interconnexion BSOB (Ball Stitch On Bail - Piqûre de perle sur perle).

6. Procédé selon au moins l'une des revendications 1 à 5, **caractérisé en ce que** l'élément de base (1) et/ou l'élément porteur sont garnis des deux côtés respectivement avec au moins un composant (2, 3, 4, 6).

7. Procédé selon au moins l'une des revendications 4 à 6, **caractérisé en ce qu'**au moins l'élément sonde de mesure (3) et au moins une partie de l'élément de base (1, 12) et/ou de l'élément porteur sont surmoulés (F), moyennant quoi un premier boîtier (7) est formé, et **en ce qu'**au moins une partie de l'élément de base (1) et/ou de l'élément porteur et notamment un élément de protection électronique (6) sont surmoulés (F), moyennant quoi un deuxième boîtier (8) est formé, lequel possède notamment un écart défini par rapport au premier boîtier (7).

8. Procédé selon la revendication 7, **caractérisé en ce que** le premier (7) et le deuxième (8) boîtier sont surmoulés en commun dans une opération de surmoulage supplémentaire, moyennant quoi un troisième boîtier commun est formé.

9. Procédé selon au moins l'une des revendications 1 à 8, **caractérisé en ce que** l'élément capteur est soumis à une opération de traitement au plasma supplémentaire (I), notamment à la fin du procédé de fabrication.
